(19) Europäisches Patentamt / European Patent Office / Office européen des brevets

(11) **EP 2 834 203 B1**

(12) **FASCICULE DE BREVET EUROPEEN**

(45) Date de publication et mention
de la délivrance du brevet:
**01.08.2018 Bulletin 2018/31**

(51) Int Cl.:
*C03C 4/00* *(2006.01)*          *C03C 21/00* *(2006.01)*
*C03C 3/085* *(2006.01)*

(21) Numéro de dépôt: **13715311.0**

(22) Date de dépôt: **13.03.2013**

(86) Numéro de dépôt international:
**PCT/FR2013/050523**

(87) Numéro de publication internationale:
**WO 2013/136013 (19.09.2013 Gazette 2013/38)**

(54) **FEUILLE DE VERRE**

GLASSCHEIBE

GLASS SHEET

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.03.2012 FR 1252320**

(43) Date de publication de la demande:
**11.02.2015 Bulletin 2015/07**

(73) Titulaire: **Saint-Gobain Glass France
92400 Courbevoie (FR)**

(72) Inventeurs:
 • **SELLIER, Julien**
   **F-75018 Paris (FR)**
 • **GY, René**
   **F-93140 Bondy (FR)**
 • **PELLETIER, Stéphanie**
   **F-75014 Paris (FR)**

(74) Mandataire: **Saint-Gobain Recherche
Département Propriété Industrielle
39 Quai Lucien Lefranc
93300 Aubervilliers (FR)**

(56) Documents cités:
EP-A1- 1 593 658          WO-A1-2008/050500
FR-A1- 2 964 655          JP-A- 2002 174 810
US-A1- 2007 060 465       US-A1- 2010 119 846

• HILL M J C ET AL: "STRESS PROFILE
CHARACTERISTICS AND MECHANICAL
BEHAVIOUR OF CHEMICALLY STRENGTHENED
LITHIUM MAGNESIUM ALUMINOSILICATE
GLASSES", GLASS TECHNOLOGY, SOCIETY OF
GLASS TECHNOLOGY, SHEFFIELD, GB, vol. 30,
no. 4, 1 août 1989 (1989-08-01), pages 123-127,
XP000039561, ISSN: 0017-1050
• DONALD I W ET AL: "Preparation and mechanical
behaviour of some chemically strengthened
lithium magnesium alumino-silicate glasses",
JOURNAL OF MATERIALS SCIENCE, SPRINGER
NETHERLANDS, NL, vol. 23, no. 8, 1 août 1988
(1988-08-01), pages 2797-2809, XP001251142,
ISSN: 0022-2461

## Description

L'invention se rapporte au domaine des feuilles de verre minces. Elle concerne plus particulièrement des feuilles de verre minces susceptibles de résister à des chocs violents.

Les feuilles de verre mince sont fréquemment employées comme verre de protection, fenêtre de visualisation ou encore écran de divers dispositifs électroniques, notamment de poche ou portables, tel que par exemple les téléphones intelligents (parfois appelés « smartphones »), les assistants numériques personnels (parfois appelés « PDA »), les tablettes, les appareils photo numériques, les lecteurs multimédia, les ordinateurs, les écrans de télévision ou d'affichage, etc. Pour des raisons liées au poids, il est également avantageux d'employer des feuilles de verre mince comme verre de couverture de capteurs solaires thermiques ou photovoltaïques.

Les feuilles de verre utilisées dans de tels dispositifs ou applications sont susceptibles d'être fortement sollicitées d'un point de vue mécanique : contacts répétés avec des objets durs et pointus, impacts de projectiles, chutes...

Pour augmenter leur résistance aux chocs, il est connu de créer une zone superficielle en compression et une zone centrale en tension, par des procédés de trempe thermique ou d'échange ionique (que l'on appelle parfois « trempe chimique »). Dans ce dernier cas, la substitution superficielle d'un ion de la feuille de verre (généralement un ion alcalin tel que le sodium) par un ion de rayon ionique plus grand (généralement un ion alcalin, tel que le potassium) permet de créer en surface de la feuille de verre des contraintes résiduelles de compression, jusqu'à une certaine profondeur. Dans l'ensemble du texte, une profondeur correspond, selon une coupe transversale, à une distance entre un point considéré et la surface de la feuille de verre la plus proche, mesurée selon une normale à ladite surface. De même, dans toute la suite du texte, les contraintes sont parallèles à la surface de la feuille de verre, et sont des contraintes d'épaisseur, au sens où, exception faite des zones de bord, la moyenne des contraintes sur toute l'épaisseur de la feuille de verre est nulle. Les contraintes superficielles en compression sont en effet équilibrées par la présence d'une zone centrale en tension. Il existe donc une certaine profondeur à laquelle se produit la transition entre compression et tension. Le profil de contrainte correspond au tracé de la contrainte (qu'elle soit de compression ou de tension) selon une coupe transversale en fonction de la distance à une des faces de la feuille de verre, mesurée selon une normale à ladite face.

Dans la plupart des applications précitées, il importe également que la feuille de verre ne fragmente pas en cas de rupture. On entend par fragmentation la capacité du verre à se rompre en formant une multitude de petits fragments (voire de particules), susceptibles d'être éjectés, ou, s'ils restent en place, de réduire fortement la visibilité au travers de la feuille.

En général, ces deux exigences (résistance au choc et fragmentation) sont contradictoires car le renforcement procuré par la présence de contraintes résiduelles après trempe est accompagné de tensions à coeur qui vont favoriser la fragmentation.

L'invention a pour but de réconcilier ces deux exigences en proposant des feuilles de verre capables de maintenir une résistance mécanique élevée même après avoir été lourdement endommagées lors de leur utilisation, comme c'est le cas par exemple suite à des chutes répétées, tout en présentant néanmoins une faible aptitude à la fragmentation.

A cet effet, l'invention a pour objet une feuille de verre dont la composition est du type aluminosilicate de lithium et comprend au plus 1% en poids d'oxyde de sodium, dont l'épaisseur est d'au plus 2 mm, possédant une zone superficielle en compression obtenue par échange ionique et une zone centrale en tension, telle que la contrainte à rupture en flexion à un test « anneau sur tripode » est d'au moins 50 MPa, après indentation Vickers sous une charge de 120 N.

Le protocole de mesure de la contrainte à rupture est détaillé plus après, dans la partie du présent texte décrivant les exemples selon l'invention.

La zone superficielle en compression est obtenue par échange ionique, de préférence à l'aide d'ions sodium. Plus de détails sur ce procédé sont donnés dans la suite de la présente description.

L'épaisseur e de la feuille de verre est de préférence d'au plus 1,5 mm, voire 1,1 mm. L'épaisseur de la feuille de verre est de préférence d'au moins 0,25 mm, notamment 0,5 mm. Les dimensions latérales de la feuille de verre dépendent de l'utilisation visée. Au moins une dimension est généralement inférieure ou égale à 40 cm, notamment 30 cm, voire 20 cm. La surface de la feuille de verre est généralement d'au plus 0,2 $m^2$, voire 0,1 $m^2$. Dans les applications de verre de couverture pour capteurs solaires, la surface de la feuille de verre sera en revanche généralement d'au moins 1 $m^2$.

La profondeur d'échange est de préférence d'au moins 40 micromètres, notamment 50 micromètres et/ou d'au plus 500, voire 300 micromètres. La méthode de mesure de la profondeur d'échange est détaillée dans la partie de la description consacrée aux exemples.

Afin de réduire la capacité du verre à se fragmenter, le paramètre K, défini comme étant la racine carrée de l'intégrale dans la zone centrale en tension du carré de la contrainte, est de préférence d'au plus 1,4 MPa.$m^{1/2}$, voire 1,3 MPa.$m^{1/2}$. En limitant la valeur du facteur K, la rupture de la feuille de verre se caractérise au contraire par la présence d'un petit nombre de fissures qui, à défaut d'être esthétiques, ont un moindre impact sur la visibilité et sur la propension à éjecter des fragments.

Les inventeurs ont pu mettre en évidence le fait que les verres selon l'invention présentaient de manière surprenante une résistance après endommagement sévère (par exemple en cas de choc) nettement améliorée en dépit d'une faible fragmentation après rupture.

La contrainte à rupture en flexion à un test « anneau sur tripode » des feuilles de verre selon l'invention est de préférence d'au moins 80, notamment 100 MPa après indentation Vickers sous une charge de 120 N. La contrainte à rupture en flexion à un test « anneau sur tripode » est avantageusement d'au moins 300 MPa après indentation Vickers sous une charge de 10 N.

Le verre de type aluminosilicate de lithium est tel que sa composition chimique comprend les oxydes suivants dans les gammes de teneurs pondérales ci-après définies :

$SiO_2$      50-80%, notamment 60-75%,
$Al_2O_3$    12-30%, notamment 17-23%,
$Li_2O$      1-10%, notamment 1-5%.

La teneur pondérale en CaO est avantageusement d'au plus 3%, notamment 2% et même 1% ou 0,5%. Il s'avère en effet que l'oxyde de calcium réduit la résistance du verre à la fissuration sous indentation.

Un verre préféré est tel que sa composition chimique comprend les oxydes suivants dans les gammes de teneurs pondérales ci-après définies :

$SiO_2$      52-75%, notamment 65-70%
$Al_2O_3$    15-27%, notamment 18-19,8%
$Li_2O$      2-10%, notamment 2,5-3,8%
$Na_2O$      0-1%, notamment 0-0,5%
$K_2O$       0-5%, notamment 0-1%
CaO       0-0,5%, notamment 0-0,1%
ZnO       0-5%, notamment 1,2-2,8%
MgO       0-5%, notamment 0,55-1,5%
BaO       0-5%, notamment 0-1,4%
SrO       0-3%, notamment 0-1,4%
$TiO_2$      0-6%, notamment 0-2%
$ZrO_2$      0-3%, notamment 0-2,5%
$P_2O_5$     0-8%.

Comme il est d'usage dans la technique, la composition chimique de la feuille de verre correspond à la composition chimique en dehors des zones échangées, donc dans la zone centrale.

Le verre du type aluminosilicate de lithium est apte à être renforcé par un échange d'ions lithium par des ions sodium. La vitesse d'échange de ce type de verre est particulièrement élevée, ainsi que sa résistance à la rayure.

L'invention a aussi pour objet :

- un dispositif électronique, notamment de poche ou portable, tel que notamment téléphone intelligent, assistant numérique personnel, appareil photo numérique, lecteur multimédia, ordinateur, tablette, télévision, comprenant au moins une feuille de verre selon l'invention, en tant que verre de protection, fenêtre de visualisation, écran, élément décoratif, transparent ou non.

- un capteur solaire, thermique ou photovoltaïque comprenant au moins une feuille de verre selon l'invention.

L'invention a encore pour objet un procédé d'obtention d'une feuille de verre selon l'invention, comprenant des étapes de fusion du verre, de formage, de découpe et d'échange ionique.

L'étape de formage peut être réalisée par différents procédés par ailleurs connus, tels que le procédé de flottage, dans lequel le verre fondu est déversé sur un bain d'étain en fusion, le laminage entre deux rouleaux, le procédé dit de « fusion-draw », dans lequel le verre fondu déborde d'un canal et vient former une feuille par gravité, ou encore le procédé dit « down-draw » dans lequel le verre fondu s'écoule vers le bas par une fente, avant d'être étiré à l'épaisseur voulue et simultanément refroidi. L'étape de découpe est avantageusement suivie d'une étape de façonnage ou de polissage des bords et/ou de la surface, avant l'étape d'échange ionique.

L'échange ionique consiste à remplacer une partie des ions lithium de la feuille de verre par des ions alcalins de plus grand rayon ionique, typiquement des ions sodium. D'autres ions peuvent également être utilisés, tels que les ions potassium, rubidium ou césium, voire les ions thallium, argent ou cuivre.

L'échange ionique est généralement réalisé en plaçant la feuille de verre dans un bain rempli d'un sel fondu de l'ion alcalin désiré. Une température élevée, mais en-dessous de la température de transition vitreuse du verre à traiter, permet d'amorcer un phénomène d'interdiffusion, impactant d'abord les couches superficielles du verre.

Il est également possible de pratiquer l'échange ionique en déposant une pâte à la surface du verre. L'échange ionique peut aussi être facilité en imposant un champ électrique ou des ultrasons.

Au moins une étape d'échange ionique est de préférence réalisée à l'aide d'un sel de sodium fondu choisi parmi les nitrates, les sulfates, les chlorures ou l'un quelconque de leurs mélanges. Un mélange de sel de sodium et de sel de potassium permet de limiter l'intensité des contraintes. Le nitrate de sodium pur est particulièrement préféré.

La température et le temps d'échange sont à ajuster en fonction de la composition du verre, de son épaisseur, et du profil de contraintes désiré.

Les exemples non limitatifs qui suivent illustrent la présente invention.

Le verre utilisé pour les exemples comparatifs C1 et C2 est un aluminosilicate de sodium possédant la composition pondérale suivante.

| | |
|---|---|
| $SiO_2$ | 62% |
| $Al_2O_3$ | 8% |
| $Na_2O$ | 12,5% |
| $K_2O$ | 9% |
| MgO | 7,5% |
| CaO | 0,5%. |

Des feuilles de verre de cette composition ont été produites par le procédé de flottage à une épaisseur de 3 mm, puis polies afin d'atteindre une épaisseur e d'environ 1 mm. Ces feuilles de verre ont été soumises à divers traitements d'échange ionique, effectués en plongeant la feuille de verre dans un bain de nitrate de potassium fondu.

Le verre utilisé pour les exemples 1 et 2 selon l'invention est un aluminosilicate de lithium présentant la composition pondérale suivante :

| | |
|---|---|
| $SiO_2$ | 68,2% |
| $Al_2O_3$ | 19,0% |
| $Li_2O$ | 3,5% |
| MgO | 1,2% |
| ZnO | 1,6% |
| $TiO_2$ | 2,6% |
| $ZrO_2$ | 1,7% |
| $Na_2O + K_2O$ | < 0,5% |

Des feuilles de verre de cette composition ont été produites à une épaisseur de 4 mm, puis polies afin d'atteindre une épaisseur e d'environ 1 mm. Ces feuilles de verre ont été soumises à divers traitements d'échange ionique, effectués en plongeant la feuille de verre dans un bain de nitrate de sodium fondu.

Le tableau 1 ci-après récapitule pour les différents exemples la température d'échange T (en °C) et le temps d'échange t (en heures), l'épaisseur e (en mm), la profondeur d'échange H (en micromètres), la valeur de la contrainte à coeur $S_c$ (en MPa), et le nombre de fragments lorsque le verre est cassé.

La profondeur d'échange est déterminée à l'aide de mesures de la masse de l'échantillon avant et après trempe chimique. Plus précisément, la profondeur H est donnée par la formule suivante :

$$ H = \frac{\Delta m}{m} \frac{M}{\Delta M} \frac{\sqrt{\pi}\, e}{\alpha} $$

Dans cette formule, m est la masse de l'échantillon avant trempe, $\Delta m$ est la variation de masse due à la trempe, M est la masse molaire du verre avant trempe, $\Delta M$ est la différence de masse molaire entre les oxydes alcalins entrant dans le verre et ceux sortant du verre, e est l'épaisseur du verre, et $\alpha$ est la concentration molaire initiale de l'oxyde alcalin sortant du verre lors de l'échange ($Na_2O$ pour les exemples comparatifs, $Li_2O$ pour les exemples selon l'invention).

La contrainte à coeur $S_c$ est tirée du profil de contrainte, déterminé à l'aide d'un microscope polarisant équipé d'un compensateur de Babinet. Une telle méthode est décrite par H. Aben et C. Guillemet, dans « Photoelasticity of glass », Springer Verlag, 1993, pp 65, 123, 124, 146. Le paramètre K peut également être calculé à partir de ce profil de contrainte.

Pour mesurer la fragmentation, les éprouvettes sont revêtues d'un film adhésif sur les deux faces, puis l'on vient impacter le verre à 1 cm d'un de ses coins, à l'aide d'une pointe carbure et d'un marteau. Le décompte du nombre de fragments se fait à au moins 2 cm du point d'impact, dans un carré de 3 x 3 cm². On considère qu'un verre ne se fragmente pas lorsque le nombre de fragments est inférieur ou égal à 2.

Tableau 1

|  | C1 | 1 | C2 | 2 |
|---|---|---|---|---|
| T (°C) | 380 | 340 | 500 | 395 |
| t (h) | 34 | 1 | 15 | 4 |
| e (mm) | 1,0 | 1,0 | 1,0 | 1,0 |
| H ($\mu$m) | 55 | 55 | 233 | 232 |
| $S_c$ (MPa) | 38 | 12 | 49 | 46 |
| Fragments | 1 | 1 | 2 | 2 |

Le tableau 2 ci-après présente les résultats obtenus en termes de contrainte à la rupture après indentation.

La contrainte à rupture en flexion anneau sur tripode après indentation est mesurée dans les conditions ambiantes de température et d'humidité, de la manière suivante. Des éprouvettes de 70 x 70 mm² sont découpées dans une feuille de verre qui n'a subi aucun traitement après sa fabrication. Après échange ionique, les éprouvettes sont nettoyées à l'eau et séchées.

Une face quelconque de chaque éprouvette est alors revêtue d'un film adhésif sur une face qui sera mise par la suite en compression. Le rôle de ce film est de permettre la localisation de l'origine de rupture.

L'indentation est réalisée sur la face opposée au film adhésif, à l'aide de poids posés par-dessus une pointe Vickers. L'éprouvette est positionnée sous la pointe de telle sorte que l'indentation soit réalisée au milieu de l'éprouvette, à 1 mm près.

La descente de la pointe sur l'éprouvette est effectuée grâce à une machine Instron 4505 munie d'un capteur de force de 5 kN. En position initiale, la pointe est placée entre 2 et 5 mm au dessus de l'éprouvette. Puis on approche la pointe du verre à une vitesse de 10 mm/min. Après contact entre la pointe et le verre, la force appliquée par la machine devient nulle et seuls les poids posés sur la pointe provoquent l'indentation du verre. L'indentation dure 20 secondes, puis la pointe est remontée par la machine.

Le verre est ensuite entreposé pendant au moins 12 h afin de stabiliser la propagation des fissures. En cas de rupture après indentation mais avant le test de flexion, la contrainte de rupture en flexion est déclarée nulle.

Le test de flexion par anneau sur tripode est réalisé à l'aide d'une machine Instron 4400R, réglée avec une vitesse de descente de la traverse de 2 mm/min, instrumentée avec un capteur de force de 10 kN, d'un anneau de 10 mm de diamètre avec un tore de 1 mm de rayon, fixée en bout de la machine Instron, et d'un socle sur lequel sont collées 3 billes de rayon 5 mm, disposées à 120° sur un cercle de 20 mm de rayon et dont le centre est confondu avec le centre de l'anneau.

L'éprouvette est placée entre ces 3 billes et l'anneau, de telle manière que la marque d'indentation soit alignée avec le centre de l'anneau, à 1 mm près. On applique alors sur l'anneau une force croissante jusqu'à la rupture de l'éprouvette. Seules les éprouvettes dont l'origine de rupture est sous l'anneau sont comptabilisées. La contrainte de rupture en fonction de la force à rupture et de l'épaisseur de l'éprouvette est donnée par la formule suivante :

$$\sigma_{(MPa)} = \frac{0,847 \times Force_{(N)}}{épaisseur_{(mm)}^{2}}$$

Tableau 2

| Indentation (N) | Contrainte à rupture (MPa) | | | |
|---|---|---|---|---|
| | C1 | 1 | C2 | 2 |
| 10 | 394 | 426 | 186 | 427 |
| 60 | 40 | 54 | 143 | 253 |
| 80 | 0 | 63 | 127 | 166 |
| 120 | 0 | 56 | 0 | 108 |

Le choix d'une composition de type aluminosilicate de lithium se révèle donc particulièrement avantageux en termes de résistance au choc, et généralement aux endommagements sévères par contact, pour un échange d'ions analogue (même profondeur H et même contrainte de tension maximale). En outre, le choix de contraintes à rupture pour les indentations les plus fortes permet d'apporter une résistance au choc particulièrement élevée.

**Revendications**

1. Feuille de verre dont la composition est du type aluminosilicate de lithium et comprend au plus 1% en poids d'oxyde de sodium, dont l'épaisseur est d'au plus 2 mm, possédant une zone superficielle en compression obtenue par échange ionique et une zone centrale en tension, telle que la contrainte à rupture en flexion à un test « anneau sur tripode » est d'au moins 50 MPa, après indentation Vickers sous une charge de 120 N et tel que sa composition chimique comprend les oxydes suivants dans les gammes de teneurs pondérales ci-après définies :

$SiO_2$        50-80%,
$Al_2O_3$      12-30%,
$Li_2O$        1-5%.

2. Feuille de verre selon la revendication 1, telle que la contrainte à rupture en flexion à un test « anneau sur tripode » est d'au moins 100 MPa, après indentation Vickers sous une charge de 120 N.

3. Feuille de verre selon l'une des revendications précédentes, telle que la contrainte à rupture en flexion à un test « anneau sur tripode » est d'au moins 300 MPa, après indentation Vickers sous une charge de 10 N.

4. Feuille de verre selon l'une des revendications précédentes, dont l'épaisseur est d'au plus 1,5 mm et d'au moins 0,25 mm.

5. Feuille de verre selon la revendication précédente, dont l'épaisseur est d'au plus 1,1 mm.

6. Feuille de verre selon l'une des revendications précédentes, telle que la profondeur d'échange est d'au moins 40 micromètres, notamment 50 micromètres, et d'au plus 500 micromètres, notamment 300 micromètres.

7. Feuille de verre selon l'une des revendications précédentes, telle que la zone superficielle en compression est obtenue par échange ionique à l'aide d'ions sodium.

8. Feuille de verre selon l'une des revendications précédentes, telle que sa composition chimique comprend les oxydes suivants dans les gammes de teneurs pondérales ci-après définies :

$SiO_2$        60-75%
$Al_2O_3$      17-30%
$Li_2O$        1-5%.

9. Feuille de verre selon la revendication précédente, telle que la teneur pondérale en CaO est d'au plus 3%, notamment 1%.

10. Feuille de verre selon la revendication 1, telle que sa composition chimique comprend les oxydes suivants dans les gammes de teneurs pondérales ci-après définies :

| | |
|---|---|
| $SiO_2$ | 52-75%, notamment 65-70% |
| $Al_2O_3$ | 15-27%, notamment 18-19,8% |
| $Li_2O$ | 2-5%, notamment 2,5-3,8% |
| $Na_2O$ | 0-1%, notamment 0-0,5% |
| $K_2O$ | 0-5%, notamment 0-1% |
| CaO | 0-0,5%, notamment 0-0,1% |
| ZnO | 0-5%, notamment 1,2-2,8% |
| MgO | 0-5%, notamment 0,55-1,5% |
| BaO | 0-5%, notamment 0-1,4% |
| SrO | 0-3%, notamment 0-1,4% |
| $TiO_2$ | 0-6%, notamment 0-2% |
| $ZrO_2$ | 0-3%, notamment 0-2,5% |
| $P_2O_5$ | 0-8%. |

11. Dispositif électronique, notamment de poche ou portable, tel que notamment téléphone intelligent, assistant numérique personnel, appareil photo numérique, lecteur multimédia, ordinateur, tablette, télévision, comprenant au moins une feuille de verre selon l'une des revendications précédentes, en tant que verre de protection, fenêtre de visualisation, écran ou élément décoratif.

12. Dispositif électronique de poche ou portable selon la revendication précédente, comprenant au moins une feuille de verre selon l'une des revendications 1 à 10 en tant que verre de protection.

13. Capteur solaire, thermique ou photovoltaïque, comprenant au moins une feuille de verre selon l'une des revendications 1 à 10.

14. Procédé d'obtention d'une feuille de verre selon l'une des revendications de feuille de verre précédentes, comprenant des étapes de fusion du verre, de formage, de découpe et d'échange ionique.

15. Procédé selon la revendication précédente, tel qu'au moins une étape d'échange ionique est réalisée à l'aide d'un sel de sodium fondu choisi parmi les nitrates, les sulfates, les chlorures ou l'un quelconque de leurs mélanges.

**Patentansprüche**

1. Glastafel, deren Zusammensetzung vom Lithium-Aluminiumsilikat-Typ ist, und höchstens 1 Gew.-% Natriumoxid umfasst, dessen Dicke höchstens 2 mm beträgt, mit einem durch Ionenaustausch erhaltenen Oberflächendruckbereich und einem zentralen Spannungsbereich, sodass die Bruchbiegespannung in einem "Stativring"-Test mindestens 50 MPa beträgt, nach Vickers-Einkerbung unter einer Belastung von 120 N und derart, dass ihre chemische Zusammensetzung die folgenden Oxide in den nachfolgend definierten Gewichtsanteilen umfasst:

| | |
|---|---|
| $SiO_2$ | 50-80 %, |
| $Al_2O_3$ | 12-30 %, |
| $Li_2O$ | 1-5%. |

2. Glastafel nach Anspruch 1, wobei die Bruchbiegespannung in einem "Stativring"-Test mindestens 100 MPa nach Vickers-Einkerbung unter einer Belastung von 120 N beträgt.

3. Glastafel nach einem der vorstehenden Ansprüche, wobei die Bruchbiegespannung in einem "Stativring"-Test mindestens 300 MPa nach Vickers-Einkerbung unter einer Belastung von 10 N beträgt.

4. Glastafel nach einem der vorstehenden Ansprüche, wobei deren Dicke höchstens 1,5 mm und mindestens 0,25 mm beträgt.

5. Glastafel nach einem der vorstehenden Ansprüche, wobei deren Dicke höchstens 1,1 mm beträgt.

6. Glastafel nach einem der vorstehenden Ansprüche, wobei die Austauschtiefe mindestens 40 Mikrometer, insbesondere 50 Mikrometer, und höchstens 500 Mikrometer, insbesondere 300 Mikrometer, beträgt.

7. Glastafel nach einem der vorstehenden Ansprüche, wobei der Oberflächendruckbereich durch Ionenaustausch mit Natriumionen erhalten wird.

8. Glastafel nach einem der vorstehenden Ansprüche, wobei ihre chemische Zusammensetzung die folgenden Oxide in den nachfolgend definierten Gewichtsanteilen umfasst:

| | |
|---|---|
| $SiO_2$ | 60-75 % |
| $Al_2O_3$ | 17-30 % |
| $Li_2O$ | 1-5 %. |

9. Glastafel nach dem vorhergehenden Anspruch, wobei der Gewichtsanteil von CaO höchstens 3 %, insbesondere 1 % beträgt.

10. Glastafel nach Anspruch 1, wobei ihre chemische Zusammensetzung die folgenden Oxide in den nachfolgend definierten Gewichtsanteilen umfasst:

| | |
|---|---|
| $SiO_2$ | 52-75 %, insbesondere 65-70 % |
| $Al_2O_3$ | 15-27 %, insbesondere 18-19,8 % |
| $Li_2O$ | 2-5 %, insbesondere 2,5-3,8 % |
| $Na_2O$ | 0-1 %, insbesondere 0-0,5 % |
| $K_2O$ | 0-5 %, insbesondere 0-1 % |
| CaO | 0-0,5 %, insbesondere 0-0,1 % |
| ZnO | 0-5 %, insbesondere 1,2-2,8 % |
| MgO | 0-5 %, insbesondere 0,55-1,5 % |
| BaO | 0-5 %, insbesondere 0-1,4 % |
| SrO | 0-3 %, insbesondere 0-1,4 % |
| $TiO_2$ | 0-6 %, insbesondere 0-2 % |
| $ZrO_2$ | 0-3 %, insbesondere 0-2,5 % |
| $P_2O_5$ | 0-8 %. |

11. Elektronisches Gerät, insbesondere Taschen- oder tragbares Gerät, wie Smartphone, Personal Digital Assistant, Digitalkamera, Multimedia-Player, Computer, Tablet, Fernseher, umfassend mindestens eine Glastafel nach einem der vorstehenden Ansprüche als Schutzglas, Sichtfenster, Bildschirm oder dekoratives Element.

12. Elektronisches Taschen- oder tragbares Gerät nach dem vorstehenden Anspruch, umfassend mindestens eine Glastafel nach einem der Ansprüche 1 bis 10 als Schutzglas.

13. Solar-, Wärme- oder Fotovoltaik-Kollektor, umfassend mindestens eine Glastafel nach einem der Ansprüche 1 bis 10.

14. Verfahren zur Herstellung einer Glastafel nach einem der vorstehenden Ansprüche für Glastafeln, umfassend die Schritte des Schmelzens, Formens, Schneidens und Ionenaustauschs des Glases.

15. Verfahren nach dem vorstehenden Anspruch, wobei mindestens ein Ionenaustauschschritt unter Verwendung eines

geschmolzenen Natriumsalzes, ausgewählt aus Nitraten, Sulfaten, Chloriden oder deren Gemischen, ausgeführt wird.

**Claims**

1. A glass sheet, the composition of which is of the lithium aluminosilicate type and comprises at most 1% by weight of sodium oxide, the thickness of which is at most 2 mm, having a surface region under compression obtained by ion exchange and a central region under tension, such that the flexural stress at break in a "ring-on-tripod" test is at least 50 MPa, after Vickers indentation under a load of 120 N and such that its chemical composition comprises the following oxides in the ranges of contents by weight defined below:

| | |
|---|---|
| $SiO_2$ | 50-80% |
| $Al_2O_3$ | 12-30% |
| $Li_2O$ | 1-10%. |

2. The glass sheet as claimed in claim 1, such that the flexural stress at break in a "ring-on-tripod" test is at least 100 MPa, after Vickers indentation under a load of 120 N.

3. The glass sheet as claimed in either of the preceding claims, such that the flexural stress at break in a "ring-on-tripod" test is at least 300 MPa, after Vickers indentation under a load of 10 N.

4. The glass sheet as claimed in one of the preceding claims, the thickness of which is at most 1.5 mm and at least 0.25 mm.

5. The glass sheet as claimed in the preceding claim, the thickness of which is at most 1.1 mm.

6. The glass sheet as claimed in one of the preceding claims, such that the exchange depth is at least 40 micrometers, in particular 50 micrometers, and at most 500 micrometers, in particular 300 micrometers.

7. The glass sheet as claimed in one of the preceding claims, such that the surface region under compression is obtained by ion exchange using sodium ions.

8. The glass sheet as claimed in one of the preceding claims, such that its chemical composition comprises the following oxides in the ranges of contents by weight defined below:

| | |
|---|---|
| $SiO_2$ | 60-75% |
| $Al_2O_3$ | 17-30% |
| $Li_2O$ | 1-5%. |

9. The glass sheet as claimed in the preceding claim, such that the content by weight of CaO is at most 3%, in particular 1%.

10. The glass sheet as claimed in claim 1, such that its chemical composition comprises the following oxides in the ranges of contents by weight defined below:

| | |
|---|---|
| $SiO_2$ | 52-75%, in particular 65-70% |
| $Al_2O_3$ | 15-27%, in particular 18-19.8% |
| $Li_2O$ | 2-5%, in particular 2.5-3.8% |
| $Na_2O$ | 0-1%, in particular 0-0.5% |
| $K_2O$ | 0-5%, in particular 0-1% |
| CaO | 0-0.5%, in particular 0-0.1% |
| ZnO | 0-5%, in particular 1.2-2.8% |

(continued)

| | |
|---|---|
| MgO | 0-5%, in particular 0.55-1.5% |
| BaO | 0-5%, in particular 0-1.4% |
| SrO | 0-3%, in particular 0-1.4% |
| $TiO_2$ | 0-6%, in particular 0-2% |
| $ZrO_2$ | 0-3%, in particular 0-2.5% |
| $P_2O_5$ | 0-8%. |

11. An electronic device, in particular a pocket or portable electronic device, such as in particular a smart phone, personal digital assistant, digital camera, multimedia player, computer, tablet or television, comprising at least one glass sheet as claimed in one of the preceding claims, as protective glass, visual display window, screen or decorative element.

12. The pocket or portable electronic device as claimed in the preceding claim, comprising at least one glass sheet as claimed in one of claims 1 to 10 as protective glass.

13. A solar thermal or photovoltaic collector, comprising at least one glass sheet as claimed in one of claims 1 to 10.

14. A process for obtaining a glass sheet as claimed in one of the preceding glass sheet claims, comprising stages of melting the glass, of forming, of cutting and of ion exchange.

15. The process as claimed in the preceding claim, such that at least one ion exchange stage is carried out using a molten sodium salt chosen from a nitrate, sulfate, chloride or any one of their mixtures.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **H. ABEN ; C. GUILLEMET.** Photoelasticity of glass. Springer Verlag, 1993, 65, , 123, , 124, , 146